# EUROPEAN PATENT APPLICATION

(11) **EP 2 037 573 A1**
(43) Date of publication of application: **18.03.2009**
(21) Application number: 07116605.2
(22) Date of filing: 17.09.2007
(51) Int. Cl.: H03F 3/193, H03F 3/45, H03F 1/02

(54) **Ultra-low power consumption low noise amplifier**

(71) Applicant: Seiko Epson Corporation, Shinjuku-ku, Tokyo 163-0811 (JP)
(72) Inventor: Gil Galí, Ignacio, c/o Epson Europe Electronics GmbH, 08190 Sant Cugat del Vallés (Barcelona) (ES); Cairo Molins, Josep Ignasi, c/o Epson Europe Electronics GmbH, 08190 Sant Cugat del Vallés (Barcelona) (ES)
(74) Representative: Carpintero Lopez, Francisco

(57) **Abstract**

The present invention is related to a low power low noise amplifier (LNA), preferably a single input to differential output low noise amplifier topology. The LNA includes at least a first circuit branch comprising a first transistor (M1) and a second transistor (M2) connected in cascade configuration to amplify an input signal. A LC tank is provided to choke signal transmission from the drain of the first transistor (M1) to the source of the second transistor (M2). The LNA of the invention provides high gain and an ultra-low power consumption.

## Description

### OBJECT OF THE INVENTION

The present invention is related to a low power, low noise amplifier (LNA), preferably a single input to differential output low noise amplifier topology.

It is an object of the present invention to provide a high gain and an ultra-low power consumption LNA, in a single to differential LNA topology.

### BACKGROUND OF THE INVENTION

A Low-Noise Amplifier (LNA), is typically used for RF receivers in wireless communication systems for obtaining power gain and reducing the noise factor. In typical radio receivers, the LNA is one of the most relevant devices of the system, due to its high influence in total system noise figure (LNA is located at the input of receiver chain and the overall noise figure of the receiver front end is dominated by the first few stages, according Frits' formula), sensitivity and power consumption of the system RF blocks.

Typically, the LNA achieves simultaneous noise and input matching (in order to optimize gain) at any given amount of power dissipation. One of the advantages of the present invention is that it obtains the above-cited performances with a high gain and ultra-low power consumption. Additionally, the invention provides a differential output which is very useful for commercial receivers (which typically have two branches i.e. I and Q branches).

The following references are related to the present invention:
H.Ma, S.J. Fang, F.Lin and H. Nakamura, "Novel Active Differential Phase Splitters in RFIC for Wireless applications", IEEE Transactions on Microwave Theory and Tecniques, vol 46, No 12, December 1998".
M. Kumarasamy, T. Tear K. Nuntha and W. Sheng, "A fully integrated variable gain 5.75-Ghz LNA with on chip Active Balun for WLAN", IEEE Radio Frequency Integrated Circuits Symposium, pp 439-442, 2003.

### SUMMARY OF THE INVENTION

A first aspect of the invention refers to a low noise amplifier (LNA) including at least a first circuit branch comprising a first transistor and a second transistor, located in cascade configuration to amplify an input signal. The LNA also comprises a LC tank to choke said input signal and avoid signal transmission from the drain of the first transistor to the source of the second transistor. In fact, signal flows to the second transistor by its gate.

The tank is formed by an inductor, preferably of a transformer, and a capacitor connected in parallel, and the value of said inductor and capacitor are calculated to provide high impedance at the resonant frequency of the LC tank. The effective resonant frequency has been designed to provide a frequency in the vicinity of the operation range of the LNA (i.e. 2.45GHz).

In the present invention, it has been found that a LC tank implemented by a differential transformer and a capacitor connected in parallel and tuned at the desired frequency (for example 2.45 Ghz), advantageously avoids RF signal transmission between the drain of the first transistor and the source of the second transistor. The LC tank has an improved choke function compared with a conventional inductor, since higher impedance at resonance frequency of the LC tank in comparison to a single inductor is achieved.

Preferably, the LNA of the invention comprises two symmetric circuit branches to form a differential amplifier having a single input to differential output configuration. The second circuit branch comprises third and fourth transistors located in a cascade configuration, and a second LC tank connected between the third and fourth transistors to avoid signal transmission from the drain of the third transistor to the source of the fourth transistor.

Preferably the LNA is provided with a differential transformer, and the inductors of the first and second LC tanks, are the windings of said transformer that avoids RF signal transmission between the drains of the first and third transistors (first amplifying stage) and the sources of the second and fourth transistors (second amplifying stage).

The present invention compared with prior-art techniques, provides a LNA having an ultra-low power consumption and a high gain in a single to differential LNA topology, due to the use of the LC tank implemented preferably by means of a single to differential transformer, between the first and the second gain stages.

### DESCRIPTION OF THE DRAWINGS

The features of the invention will be better understood by reference to the accompanying drawings, which illustrate preferred embodiments of the invention.
Figure 1.- shows the topology of the LNA according to a preferred embodiment of the present invention.
Figure 2.- shows a diagram of the insertion losses (from ports 1-2, S(2,1) and ports 1-3, S(3,1) and return losses S(1,1). The scattering parameters S(2,1) and S(3,1) represent the transmision coefficient between the input port (1) and the output ports (2 and 3) respectively. This parameters are related with the gain of the structure. As can be seen the maximum gain is obtained in the vicinity of 2.45GHz, which is the interest operation frequency band. S(1,1) corresponds to the reflection at port 1.
Figure 3.- diagram (a) shows a simulated noise figure with a load impedance matched at the output ports , and diagram (b) shows the output differential phase vs frequency.

### DETAILED DESCRIPTION OF PREFERRED EMBODIMENTS

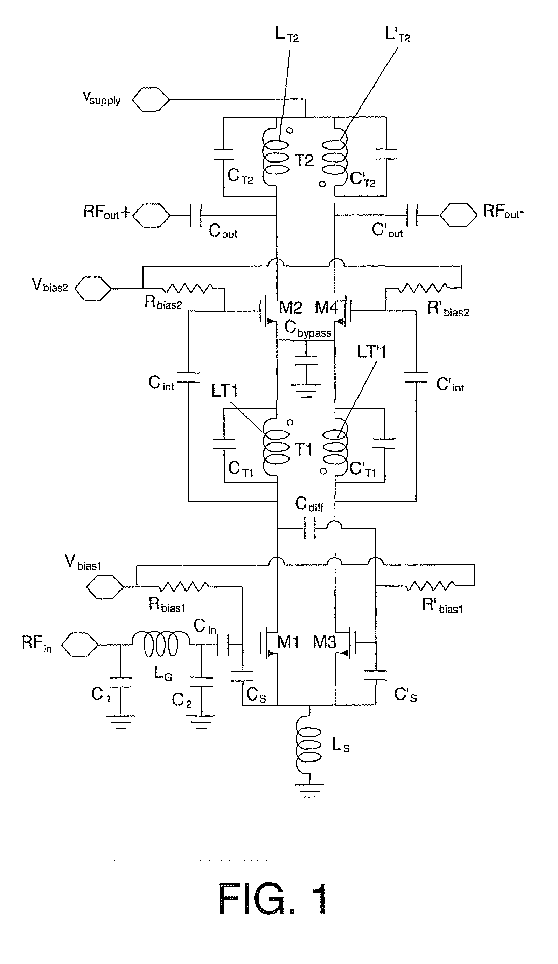

Figure 1 shows a preferred embodiment of a LNA according to the present invention, which comprises a first circuit branch formed by a first transistor (M1) and a second transistor (M2) located in cascade configuration to amplify an input signal.

The first and the second transistors (M1,M2) are arranged as common source transistors, and a first LC tank is connected between the drain of the first transistor (M1) and the source of the second transistor (M2), to choke a signal between said nodes of the first and second transistors.

The first LC tank is formed by a first inductor (Lt1), corresponding to a part of a transformer (T1) and a first tank capacitor (Ctl) connected in parallel, the value of said inductor, transformer coupling factor, and capacitor being calculated to provide a high impedance at the resonant frequency of the LC tank. The ideal coupling factor of the transformer is 1, although in practical embodiments it may be less than 1, for instance 0.7.

The drain of the first transistor (M1) is coupled to the gate of the second transistor (M2) through a first capacitor (Cint) selected to apply or transfer a RF signal at the drain of the first transistor (M1) to the gate of the second transistor (M2).

An input terminal (RFin) to receive said input signal, is coupled to the gate of the first transistor (M1) through a matching network formed by a first and a second matching capacitors (C1,C2) and a matching inductor (Lg) connected in a π-configuration. Alternatively the matching network can be connected in a T-configuration. This matching network is used to deliver maximum amount of power transference from the input terminal (RFin) to the LNA and to minimise noise power.

A series decoupling capacitor (Cin) is connected between the matching network and the gate of the first transistor (M1), in order to avoid DC contribution over the RF input.

In this preferred embodiment, the low noise amplifier comprises a first and second symmetric circuit branches to form a differential amplifier having a single input terminal (Rfin) and differential output terminals (Rfout+,Rfout-). Then, a second circuit branch comprises third and fourth transistors (M3,M4) coupled also in a cascaded configuration, are arranged as common source transistors. The drain of the third transistor (M3) is coupled to the gate of the fourth transistor (M4) through a second capacitor (Cint), to transfer a RF signal to the gate of the fourth transistor (M4). As it can be observed in figure 1, after the first amplifying stage, the implementation of the amplifier is fully symmetrical to ensure a good differential performance of the amplifier.

A second LC tank, connected between the drain of the third transistor (M3) and the source of the fourth transistor (M4), is formed by a second inductor (Lt1'), corresponding to a part of the transformer (T1) and a second tank capacitor (Ct1') connected in parallel, that is also calculated to provide a high impedance at the resonant frequency of the LC tank and avoid signal transmission between said nodes of the transistors.

The first and the second LC tanks are the windings of a differential transformer (T1), and two capacitors (Ct1,Ct1') are connected in parallel and are tuned at the desired frequency (in this case 2.45 GHz), to avoids RF signal transmission between (M2-M4) sources and (M1-M3) drains.

The gate of the third transistor (M3) is coupled to the drain of the first transistor (M1) by means of a third capacitor (Cdiff), which value is selected to copy the RF signal from one branch to the other one, and at the same time block the DC current.

First and second shunt capacitors (Cs,Cs') are respectively connected in shunt configuration with capacitance Cgs (capacitance gate-source) of transistors (M1) and (M3) in order to increase matching controllability and improve noise figure. In particular, shunt capacitors (Cs,Cs') are respectively connected between the gate and the source of the first and third transistors (M1,M3). Capacitors (Cs,Cs') are included in the input matching and allow a certain degree of controllability since they increase the effective Cgs of transistors (M1,M3).

The drains of the second and fourth transistors (M2,M4) are coupled respectively to output terminals (RFout+, RFin-), preferably by means of first and second output capacitors (Cout,Cout'), in order to avoid DC contribution over the differential output. The output terminals (RFout+, RFin-) provide a 180° differential output.

In this embodiment, the drains of the second and fourth transistors (M2,M4) are connected to a DC supply source through a second differential transformer (T2) formed by third and fourth coupled inductors (Lt2,Lt2'). This second transformer (T2) is used to provide output matching and to perform good 180° output differential signal.

The ideal coupling factor of (T1) and (T2) is 1, but in practial implementations the coupling factor of the transformers is lower than 1. The simulations have been performed with a coupling factor of 0.7.

More in detail, the third inductor (Lt2) is connected between the drain of the second transistor (M2) and the DC power supply, and the fourth inductor (Lt2') is connected between the drain of the fourth transistor (M4) and the power supply. Third and fourth inductors (Lt2,Lt2') are connected in parallel respectively with third and fourth tank capacitors (Ct2,Ct2'), to form LC tanks respectively in the first and second circuit branches to avoid RF signal transmission to the DC power supply.

A bypass capacitor (Cbypass) is connected between ground and the sources of the second and fourth transistors (M2,M4), to provide a reliable path to ground for the RF signal.

The sources of the first and third transistors (M1,M3) are coupled to ground, through a degeneration inductor (Ls). The degeneration inductor (Ls) provides also another degree of freedom with regard to impedance matching. Moreover, it is designed to increase the impedance at node formed by (M1,M3) sources, because it improves the balanced gain and phase of the device. The reason to increase this node impedance is due to the fact that although the symmetric circuit configuration provides ideal 180° phase difference between branches, gain and phase could be degraded if this impedance is not controlled.

In this amplifier, the first and the third inductors (Lt1,Lt2) and the degeneration inductor (Ls), provide a dc current path from the dc power supply to ground. Similarly in the second circuit branch, the second and fourth inductors (Lt1',Lt2') and (Ls) also provide a dc current path from the dc power supply to ground. Therefore, in this arrangement the same DC current is used for the pair of transistors (M1-M2) and for the pair of transistors (M3-M4), therefore saving power compared with cascaded amplifiers topologies. The current for each branch is equivalent if they are designed symmetrically.

The second amplification stage formed by transistors (M2,M4) stacked over the first amplification stage (M1,M3), reduce the noise impact in the structure and increase the LNA gain. The circuit of this implementation is fully symmetrical from the first amplification stage to the voltage supply.

Transistor biasing is carried out in a conventional voltage bias manner. In particular, first and second biasing resistors (Rbias1,Rbias1') are connected respectively between the gate nodes of the first and third transistors (M1,M3) and a first biasing voltage terminal (Vbias1). Third and fourth biasing resistors (Rbias2,Rbias2'), are connected respectively between the gate nodes of the second and fourth transistors (M2,M4) and a second biasing voltage terminal (Vbias2)..

It is significant to note that the (M2-M4) stage may present the role of any cascade gain stage following a first amplifier formed by (M1-M3), since the bypass capacitor (Cbypass) provides a path to ground for the RF signal. In particular, the (M2-M4) stage could play the role of the transconductance stage of a following mixer device. In other words, this structure can be seen just as a LNA or a LNA with part of a mixer stage requiring the same power consumption.

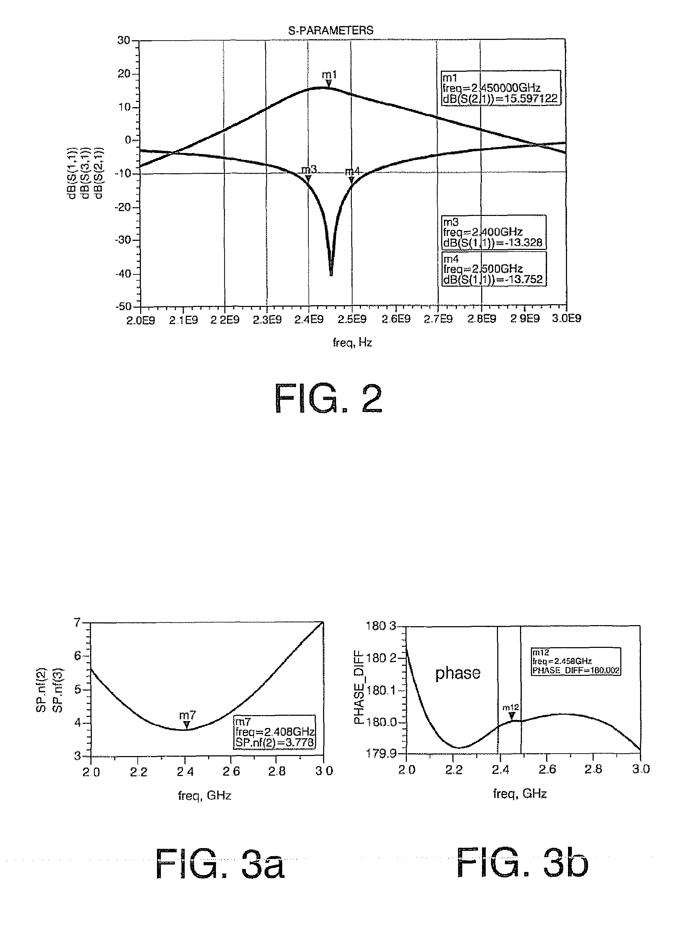

From S-parameters simulations according to figure 2, it can be observed a good matching (S(1,1)<15dB) and high gain performance (S(2,1)=16dB) as well as good noise figure performance (NF<4dB) and excellent differential output with 180.0°±0.1° accuracy in the operation frequency range.

The invention also refers to an integrated circuit and to a wireless communication device, including a low noise amplifier according to the present invention.

The invention allows the use of a good quality transformer instead of a conventional inductor, thereby also reducing the surface required in a semiconductor die.

Further embodiments of the invention are described in the attached dependent claims.

The invention has been described according to some preferred embodiments of it, but for a skilled person in the art, it will be clear that many variations may be made to the preferred embodiments without departing from the object of the claimed invention.

## Claims

1. A low noise amplifier including at least a first circuit branch, said first circuit branch comprising a first transistor (M1) and a second transistor (M2) connected in cascaded configuration to amplify an input signal, **characterised in that** it further comprises a first LC tank connected between the drain of the first transistor (M1) and the source of the second transistor (M2), wherein the LC tank is calculated to choke signal transmission.

2. Low noise amplifier according to claim 1 wherein the first and the second transistors (M1,M2) are arranged as common source transistors.

3. Low noise amplifier according to claim 1 or claim 2 wherein the drain of the first transistor (M1) is coupled to the gate of the second transistor (M2) through a first capacitor (Cint) selected to apply a signal at the drain of the first transistor to the gate of the second transistor.

4. Low noise amplifier according to any of the preceding claims wherein it comprises an input terminal (RFin) to receive said input signal, and wherein said input terminal is coupled to the gate of the first transistor (M1).

5. Low noise amplifier according to claim 4 wherein said input terminal is connected to the gate of the first transistor through a matching network, said matching network comprising a first and second matching capacitors (C1,C2) and a matching inductor (Lg) connected in a π-configuration or in a T-configuration.

6. Low noise amplifier according to claim 4 or 5 wherein the matching network is connected between said input terminal (Rfin) and the gate of the first transistor.

7. Low noise amplifier according to claim 6 wherein a series capacitor (Cin) is connected between the matching network and the gate of the first transistor, to avoid DC contribution over the RF input.

8. Low noise amplifier according to any of the preceding claims wherein it comprises a first and second symmetric circuit branches to form a differential amplifier, having a single input terminal (Rfin) and differential output terminals (Rfout+,Rfout-).

9. Low noise amplifier according to claim 8 wherein the second circuit branch comprises third and fourth transistors (M3,M4) connected in a cascaded configuration and arranged as common source transistors, wherein the drain of the third transistor (M3) is coupled to the gate of the fourth transistor (M4) through a second capacitor (Cint'), and wherein a second LC tank is connected between the drain of the third transistor (M3) and the source of the fourth transistor (M4).

10. Low noise amplifier according to claim 9 wherein the gate of the third transistor (M3) is coupled to the drain of the first transistor (M1) by means of a third capacitor (Cdiff).

11. Low noise amplifier according to claims 9 or 10 wherein a first and a second shunt capacitors (Cs,Cs') are respectively connected between the gate and the source of the first and third transistors (M1,M3).

12. Low noise amplifier according to any of the preceding claims wherein the first LC tank is formed by a first inductor (Lt1) and a first tank capacitor (Ct1) connected in parallel, the LC tank being calculated to provide high impedance at the resonant frequency of the LC tank to avoid signal transmission.

13. Low noise amplifier according to any of the claims 9 to 12 wherein the second LC tank is formed by a second inductor (Lt1') and a second tank capacitor (Ct1') connected in parallel, the LC tank being calculated to provide a high impedance at the resonant frequency of the LC tank to avoid signal transmission.

14. Low noise amplifier according to claims 12 and 13 wherein the first and the second inductors (Lt1,Lt1') are coupled and are the windings of a first transformer (T1).

15. Low noise amplifier according to any of the claims 9 to 14 wherein the drains of the second and fourth transistors (M2,M4) are coupled respectively to output terminals (RFout+,RFout-) to provide a differential output.

16. Low noise amplifier according to claim 15 wherein the drains of the second and fourth transistors are coupled to the output terminals (RFout+,RFout-) respectively by means of first and second output capacitors (Cout,Cout').

17. Low noise amplifier according to any of the claims 9 to 16, wherein the sources of the first and third transistors (M1,M3) are coupled to ground.

18. Low noise amplifier according to claim 17 wherein the sources of the first and third transistors are connected to ground through a degeneration inductor (Ls).

19. Low noise amplifier according to any of the claims 9 to 18, wherein the drains of the second and fourth transistors (M2,M4) are supplied by a DC source.

20. Low noise amplifier according to claim 19 wherein the drains of the second and fourth transistors are connected to a DC supply through a second differential transformer (T2) formed by third and fourth inductors (Lt2,Lt2').

21. Low noise amplifier according to claim 20 wherein the third inductor (Lt2) is connected between the drain of the second transistor (M2) and the DC power supply, and the fourth inductor (Lt2') is connected between the drain of the fourth transistor (M4) and the power supply.

22. Low noise amplifier according to claim 20 or 21, wherein the third and fourth inductors (Lt2,Lt2') are connected in parallel respectively with third and fourth tank capacitors (Ct2,Ct2'), to form a LC tanks in the first and second circuit branches to provide a RF choke.

23. Low noise amplifier according to any of the claims 9 to 22 wherein a bypass capacitor (Cbypass) is connected between ground and the sources of the second and fourth transistors (M2,M4), to provide a path to ground for the RF signal.

24. Low noise amplifier according to any of the preceding claims wherein it is adapted to operate within a band having a central frequency of approximately 2.45 GHz.

25. Integrated circuit having a semiconductor die including at least one low noise amplifier according to any of the claims 1 to 24.

26. wireless communication device including a low noise amplifier according to any of the claims 1 to 24.
